# EUROPEAN PATENT APPLICATION

(11) **EP 4 845 381 A2**
(43) Date of publication of application: **25.11.2026**
(21) Application number: 26175018.6
(22) Date of filing: 28.04.2026
(51) Int. Cl.: H10W 90/10, H10W 70/60, H10W 90/00

(54) **SYSTEM-ON-PANEL DEVICE**

(30) Priority: 29.04.2025 US 202519193466
(71) Applicant: Avago Technologies International Sales Pte. Limited, Singapore 768923 (SG)
(72) Inventor: Karikalan, Sam, Irvine, CA 92618 (US); Tsau, Liming, Irvine, CA 92620 (US); Mayukh, Mayank, Fort Collins, CO 80528 (US)
(74) Representative: Dilg, Haeusler, Schindelmann Patentanwaltsgesellschaft mbH

(57) **Abstract**

In an embodiment, a system-on-panel device is provided as an alternative to standard device packaging structures. The system-on-panel device includes a panel substrate, such as a glass panel or the like. A redistribution layer is on a surface of the panel substrate and includes therein multiple wiring connections, which may be provided in multiple layers in some instances. Device dies (e.g., microchip devices) are mounted on the redistribution layer and electrically connected to at least one wiring connection in the redistribution layer. A connector is mounted on the redistribution layer for permitting electrical connections to the wiring connections in the redistribution layer. The connector may receive power and/or signals from an external device. The redistribution layer permits connections between different die, components, and connectors disposed on the panel substrate to be made. In some examples, the system-on-panel device may be integrated into a system-in-box design.

## Description

### BACKGROUND

Integrated circuit devices are increasingly relying on combinations of multiple device dies (chips) and larger and larger planar area device dies for applications in artificial intelligence and high-performance computing. Existing packaging designs for such devices face difficulties associated with the use of these multiple and larger device dies. For example, future devices adopting a 2.5D packaging design, which incorporates multiple dies, an interposer, and a packaging substrate, will necessarily require ever larger interposers and packaging substrates as the incorporated device dies increase in planar area and/or number. These increased sizes generate challenges related to warpage, maintaining mechanical stability at interconnection joints, and overall package flatness during manufacturing and assembly. For example, due to differences in thermal expansion properties, it can be difficult to maintain intra-device interconnections between the various components in a packaged device.

In view of the increasing device sizes and the limitations of current packaging designs, new packaging designs and concepts are necessary to allow continued increases in integrated circuit device performance. Such new designs and concepts may also provide lower costs, improved manufacturability, and new end uses.

### SUMMARY

In an embodiment, a system-on-panel device includes a panel substrate and a redistribution layer on the panel substrate. The redistribution layer includes a plurality of wiring connections therein. A plurality of device dies are disposed on the redistribution layer and electrically connected to one or more wiring connections in the plurality of wiring connections of the redistribution layer. A connector is on the redistribution layer and electrically connected to at least one wiring connection in the plurality of wiring connections.

In another embodiment, a system-on-panel device includes a panel substrate; a redistribution layer on a first surface side of the panel substrate and including a plurality of wiring connections in a plurality of wiring layers; a first device die mounted on the redistribution layer; a second device die mounted on the redistribution layer; and a connector on the first surface side of the panel substrate and electrically connected to at least one wiring connection in the plurality of wiring connections. The first device die is electrically connected to the connector via the at least one wiring connection in the plurality of wiring connections and to the second device die via at least one other wiring connection in the plurality of wiring connections.

In an embodiment, a system-in-box includes a casing, an external connector on an exterior wall of the casing, and a system-on-panel device inside the casing. The system-on-panel device may include: a panel substrate; a redistribution layer on the panel substrate and including a plurality of wiring connections; a plurality of device dies on the redistribution layer and electrically connected to at least one wiring connection in the plurality of wiring connections; and a panel connector on the redistribution layer and electrically connected to at least one wiring connection in the plurality of wiring connections. The external connector is connected to the panel connector via, for example, either an optical fiber or an electrical wire or cable.

As used in the present disclosure, terms such as "has," "with," "includes," or "including," when used in a manner such as component X has/with/includes component Y, is non-exclusive and open-ended so as to indicate component X comprises components Y such that other aspects, components, or elements other than component Y may also be a part of component X. Similarly, when an element is referred to herein as being "connected" or "coupled" to another element, it is to be understood that the element can be directly connected to the other element, or have intervening elements present between these connected or coupled elements. In contrast, when an element is referred to as being "directly connected" or "directly coupled" to another element, it should be understood that no intervening elements are present in the "direct" connection or coupling between these elements. However, the existence of a direct connection does not exclude other connections in which intervening elements may be present. Likewise, when an element is referred to herein as being "bonded to," "mounted on," "disposed on," or "on" another element, it is to be understood that such an element can be directly bonded to, mounted on, disposed on, or on the other element (without any intervening elements) or have intervening elements present between the bonded, mounted, or disposed elements. In contrast, when an element is referred to as being "directly bonded to," "directly mounted on," "directly disposed on," or "directly on" another element, it should be understood that no intervening elements are present. Similarly, when an element is referred to herein as being "electrically connected" to another element, it is to be understood that the element can be directly connected to the other element or can be indirectly connected by have intervening conductive elements present between the described electrically connected elements. In some instances, such intervening conductive elements may be intermittently conductive, such as a switch that may be opened or closed during operation.

### BRIEF DESCRIPTION OF THE DRAWINGS

Fig. 1 depicts a cross-sectional view of a package configuration of a comparative example.
Fig. 2 depicts a planar view of the package configuration of the comparative example.
Fig. 3 depicts a cross-sectional view of a system-on-panel of an embodiment.
Fig. 4 depicts a planar view of a system-on-panel of an embodiment.
Fig. 5 depicts a modification of a configuration of a system-on-panel according to an embodiment.
Fig. 6 depicts a system-on-panel incorporated into a system box of another embodiment.

### DETAILED DESCRIPTION

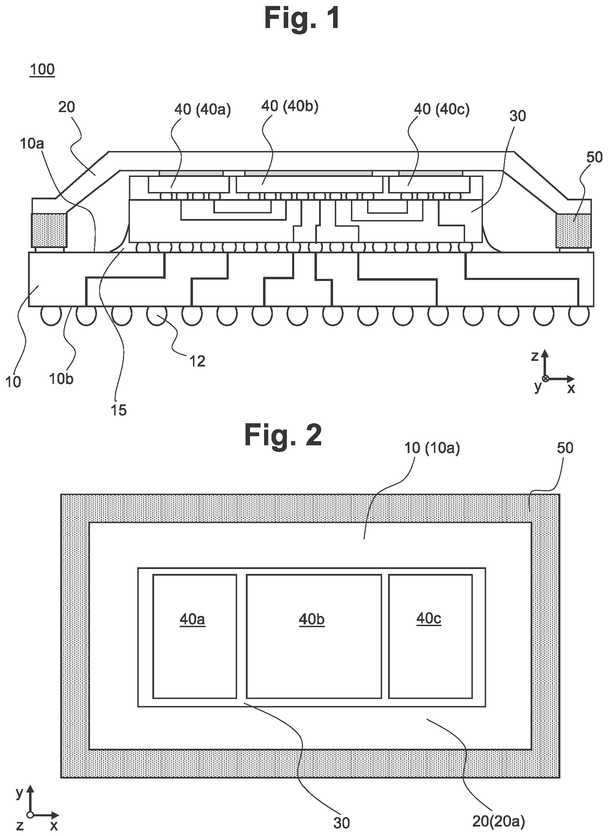

Fig. 1 schematically depicts a packaged integrated circuit device 100 ("packaged device 100") of a comparative example. The packaged device 100 includes a package substrate 10, a lid 20, an interposer 30, multiple dies 40 (40a, 40b, 40c), and a stiffener ring 50. An underfill resin 15 is present between the interposer 30 and package substrate 10. In general, this packaged device 100 may be said to have a 2.5D type flip-chip type package arrangement or structure.

Fig. 2 depicts a planar (overhead) view of packaged device 100 in simplified form without lid 20 or underfill resin 15 depicted. The depicted overall shape, form factor, positioning of interconnection joints, relative component sizes, numbers of interconnections, solder ball arrangements and/or pitch shown in this example are not limited to those depicted. In general, such aspects may be varied as appropriate to intended end use or design preferences. For example, stiffener 50 may be offset from the outermost edge of the package substrate 10.

Package substrate 10 is a wiring substrate with pads, terminals, lands, or the like ("interconnections") for making electrical connections on its upper (in the arbitrary orientation depicted in Fig. 1) surface side 10a ("side 10a") and its lower surface side 10b ("side 10b"). In the present example, package substrate 10 is a wiring substrate in 2.5D-type package structure providing connections between L1 interconnections (interposer to package substrate connections) and L2 interconnections (package substrate to device board/socket terminals connections). One or more internal wiring layer of package substrate 10 connects interconnections on side 10a to those on side 10b. The side 10b has solder balls 12 (also sometimes referred to as bumps) thereon, which permit the packaged device 100 to be mounted in a larger device, such as a computer, a server, a workstation, a circuit board, or the like. In general, the planar size of package substrate 10 is greater than that of the other elements within packaged device 100.

In this comparative example, a stiffener 50 is disposed on side 10a of packaged substrate 10 along an outer perimeter region to limit or control packaged device warpage. Inclusion of such an element may serve to limit warpage but at the cost of increased internal stress in components and/or at interconnections between components. For example, stresses resulting from differences in the coefficient of thermal expansion (CTE) of various components may arise with changes in temperatures related to manufacturing processes and/or device operating conditions.

Interposer 30 provides connections between pads (interconnections) on its lower surface side and pads (interconnections) on its upper surface side. Interposer 30 may be a silicon interposer, an organic interposer, a reconstituted wafer (RW) interposer, a glass interposer, or the like. In this depicted example, multiple internal wiring layers are present in interposer 30. In some other examples, interposer 30 may incorporate various embedded components (e.g., resistors, capacitors, circuit elements, etc.) and local interconnections between such components and dies 40. The planar area of interposer 30 is generally less than that of package substrate 10, often less than twice as large as that of package substrate 10 (or packaged device 100) overall.

Relatedly, as seen in Fig. 2, the planar dimensions of interposer 30 in a planar direction can be substantially less than that of package substrate 10. With such differences in dimensions to go along with differences in materials, there may be a significant challenge to maintaining the mechanical integrity at various interconnection joints as well as maintaining overall flatness of packaged device 100 across various thermal conditions of the manufacturing and assembly cycle.

On an upper surface of interposer 30 one or more dies 40 are disposed. Fig. 1 shows three different die 40 (die 40a, die 40b, die 40c) mounted on interposer 30. There is no particular limitation with respect to the number of dies 40 that might be utilized in this context. There may be three, less than three, or more than three die 40 depending on end use applications and the like. Likewise, the planar shapes, relative sizes, positioning, arrangements, and the like for each die 40 is not limited to the depicted examples.

In general, each die 40 is an integrated circuit device. In some contexts, a die 40 may be referred to as a chip, a microchip, a microprocessor, a processing unit, a storage unit, a component device, a semiconductor device, or the like. Die 40 may be, without limitation, a processor, a complementary metal oxide semiconductor (CMOS) chip, a memory chip, an application specific integrated circuit (ASIC) chip, graphics processing unit, digital signal processor, or the like. When multiple dies 40 are provided, each may be a different type or the same type. That is, for example, die 40b may be an ASIC chip, and die 40a and die 40c may be memory chips. Alternatively, each of die 40a, 40b, and 40c may be the same type of chip or unit.

Fig. 1 shows a stiffener 50 that is adhered to side 10a of package substrate 10 by resin, adhesive, or solder. Fig. 2 shows that stiffener 50 is provided as unitary rectangular frame-like element surrounding the outer periphery of interposer 30. However, this is for example only. In general, the inclusion, size, shape, positioning, composition, materials, and the like of stiffener 50 can be selected as appropriate in view of the requirements for stiffness and/or flatness in packaged device 100.

Lid 20 is shown in Fig. 1 as mounted on stiffener 50 and covering the dies 40 as well as side 10a of package substrate 10. In this example, each die 40 is separately connected to lid 20 by adhesive, paste, or the like. Lid 20 provides physical protection to the dies 40 and may also be used to promote heat dissipation. In general, the lid 20 may provide additional stiffness control, environmental control, and/or thermal management.

Fig. 1 shows inclusion of underfill resin 15 between package substrate 10 and interposer 30. A similar resin may also be provided between dies 40 and interposer 30. As depicted in Fig. 1, dies 40 are surrounded by an encapsulating resin. Additional resins may be present in packaged device 100.

Generally, packaged device 100 would ultimately be mounted to a larger printed circuit board (PCB) or the like via the solder balls 12 to function as part of a larger device such as a server, a work station, a computer terminal, a supercomputer, or the like. Such a larger device may incorporate more than one packaged device 100 and/or additional components, such as communication interfaces, input/output connectors, power terminals, memory (storage), and the like.

### System-on-Panel

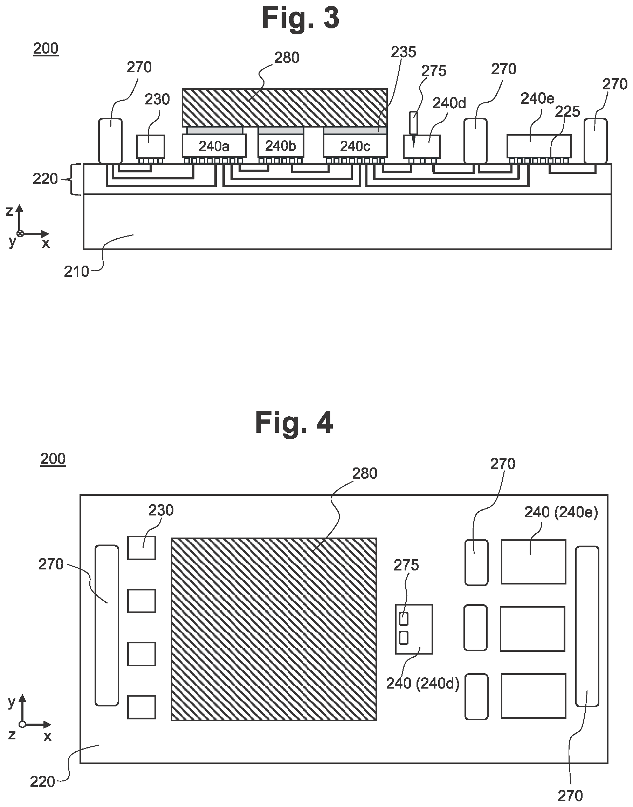

Fig. 3 depicts a cross-sectional view of a system-on-panel 200 (device assembly) of an embodiment, and Fig. 4 depicts a planar view of the system-on-panel 200. In general, a system-on-panel 200 represents an alternative packaging strategy for multiple die systems as compared to that of the 2.5D packaged device 100 described above. In this context, a "system" refers an overall device or apparatus with multiple dies (e.g., chips) or sub-components that are connected to each other to provide one or more system functions in cooperation with one another. For example, a system may comprise one or more processor dies connected to one or more memory dies to perform calculations, but is not limited thereto. A system-on-panel is a multiple component system in which the components are mounted on a panel-like substrate, such as panel substrate 210.

In packaged device 100, and similar configurations, stresses such as those resulting from coefficient of thermal expansion (CTE) mismatch between the interposer 30 type and the package substrate 10 may cause dislocation at the interconnections therebetween and/or increase internal stresses/strains in the packaged components. Such concerns and issues with overall flatness and/or warpage tend to limit the maximum size of the packaged device 100. For example, a maximum planar dimension much beyond 150 mm would be difficult to achieve with current interposer designs. However, such a limitation to approximately 8× to 10× reticle size may limit final device performance by limiting the size and/or number of dies incorporated.

In the system-on-panel 200, a panel substrate 210 is used. Panel substrate 210 provides support functions similar to those of package substrate 10 with most of the connectivity functions of package substrate 10 and interposer 30 being provided by the redistribution layer (RDL) 220 which is formed on one surface of the panel substrate 210. For example, panel substrate 210 (and thus system-on-panel 200) may have a maximum planar dimension of greater than 150 mm, for example, 500 mm to 600 mm. Fig. 4 shows panel substrate 210 to have a rectangular shape, but the drawing is merely schematic and no limitation on relative sizing of the dimensions of panel substrate 210, nor the components thereon, is to be implied by the drawings. Likewise, positioning and placement of the various depicted components is not limited to the depicted examples. In other examples, panel substrate 210 may be square or another planar shape besides rectangular. Panel substrate 210 may be a glass panel in some examples. For example, panel substrate 210 may be a low CTE, high modulus carrier structure. While depicted in Fig. 3 as a single, unitary component, in other examples, panel substrate 210 may incorporate multiple layers of the same or different materials. In general, there is no limitation on the material(s) from which the panel substrate 210 can be formed. Panel substrate 210 can be or comprise, without limitation, glasses, ceramics, metals, and/or plastics.

In the present example, RDL 220 is redistribution layer that has multiple, distinct wiring layers therein permitting various wiring connections (interconnections) to be made between the multiple dies 240 (240a, 240b, 240c, 240d, 240e) and between such dies and other components in the system-on-panel 200. The number of wiring layers within RDL 220 is not limited to any particular number, nor is the number of dies 240 connected thereto via interconnections 225. The number of wiring layers in RDL 220 may be greater than that depicted or less than that depicted in Fig. 3. In general, the number of wiring layers in RDL 220 may be set as appropriate to the design and/or final application of concern. The number and sizing of individual wiring connections within RDL 220 or individual wiring layers thereof may likewise be set as appropriate for the design and/or final application of system-on-panel 200.

For example, the wiring connections/interconnections within RDL 220 may be a conductive material such as a metal such as copper, aluminum, tungsten, gold, and/or alloys of such conductive metals alone or in combination. Insulating portions of RDL 220 may be non-conductive materials such as silicon oxide, polymeric resins, glasses, or the like alone or in combination. For example, different wiring layers may comprise different conductive materials and/or different non-conductive materials within the same RDL 220. In general, a wiring layer within RDL 220 refers to wiring portions that run in a plane generally parallel to the main surface of panel substrate 210. In some examples, wiring layers may be connected to one another in a vertical (interlayer) direction (direction generally orthogonal to the main surface of panel substrate 210) by other wiring portions. Vertical (or substantially so) wiring connections may be referred to as interlayer connections, vias, contact plugs, or otherwise in some examples.

In general, each die 240 is a device die that may be an integrated circuit device. In some contexts, a device die or a die 240 may be referred to as a chip, a microchip, a microprocessor, a processing unit, a storage unit, a component device, a system component, an integrated circuit chip, an IC device, a semiconductor device, or the like. A die 240 may be, without limitation, a processor, a complementary metal oxide semiconductor (CMOS) chip, a memory chip, an application specific integrated circuit (ASIC) chip, graphics processing unit, digital signal processor, or the like. In general, without limitation, a die 240 or a device die is formed as a sub-portion or sub-unit of a larger unit, such as semiconductor wafer, that has been separated or divided from the larger unit in an earlier fabrication process. However, various post-separation/post-division processes may have been performed on the die 240 or device die prior to incorporation in system-on-panel 200. For example, a die 240 may be optionally encapsulated, passivated, or otherwise protected by additional processing. Solder balls, solder bumps, or other conductive structures for forming interconnections 225 may be provided on a die 240 before incorporation in system-on-panel 200. When multiple dies 240 are provided, each may be a different type or the same type. That is, for example, die 240b may be an ASIC chip, and die 240a and die 240c may be memory chips. Alternatively, each die 240 may each be the same type of chip or unit.

In addition, system-on-panel 200 in this example incorporates one or more circuit components 230 ("components 230") and one or more connectors 270. In some examples, components 230 may be optional. Likewise, in some examples, connectors 270 may be optional or otherwise provided. For example, a backside connector 275 ("connector 275") is depicted by which a die 240 (die 240d, in this example) may be directly connected to an external component, power terminal or the like.

Without limitation, a component 230 may be a passive circuit component such as resistor, a capacitor, or other such basic circuit element. In some examples, a component 230 may be a system sensor, such as a thermal monitoring sensor, a thermostat, a protective fuse, a battery, or the like. Fig. 4 shows a plurality of components 230. The number, positioning, and sizing of such components 230 is not limited to that depicted. Such components 230 may be the same or different types.

In Fig. 3, dies 240 and a component 230 are shown connected to RDL layer 220 via interconnections 225. For example, an upper layer of RDL layer 220 may have terminals, pads, lands, or the like corresponding to similar structure on the dies 240 (or passive components 230) which are then physically and electrically connected thereto via solder balls/bumps. That is, interconnections 225 may be solder balls or solder bumps. However, the method or manner of connecting components to the RDL layer 220 is not particularly limited. Interconnections 225 may be, or comprise, pins, contacts, sockets, or the like. It may also be possible for different dies or components to be attached using different methods within the same system-on-panel 200. That is, interconnections 225 may differ in type for different dies or components. Additionally, in some examples, bonding wires, wire connectors, wire leads, pins, sockets, or the like may be incorporated for connecting dies 240 and/or components 230 to RDL layer 220. Similarly, bonding wires, wire connectors, wire leads, and the like may be supplied for directly connecting one or more die 240 or component 230 to other dies 240 and/or components 230 without inclusion of wiring connections within RDL layer 220.

Fig. 3 and Fig. 4 depict multiple connectors 270 on an upper surface of the panel substrate 210, more specifically the upper surface of the RDL 220. In some instances, a connector 270 may be referred to as a panel-mounted connector, a panel connector, a plug, a socket, or the like. The number, placement, size, positioning, and type of connectors 270 in system-on-panel 200 is not limited to that depicted or otherwise. One or more of the connectors 270 may be electrical connectors for providing electrical power to system-on-panel 200 from an external source, sub-components thereof, or the like. Such connectors 270 may be referred to as an electrical power supply connector. One or more of the connectors 270 may be signal connectors (signal I/O connectors) for supplying external commands to elements (e.g., dies 240) and returning information (data signals and the like) to an external system to which the system-on-panel 200 is connected, installed within, or otherwise integrated. One or more connectors 270 may be optical connectors (e.g., fiber optic connectors) for handling input and/or output of optical signals. Such connectors 270 may be referred to as an optical signal connector or an optical connector. For example, connectors 270 may incorporate optical signal transducers or the like for conversion of light to electrical signals. A connector 270 may combine both power, I/O, electrical, and optical related functions in a single connector structure. Similarly, other than the positioning/connectivity of connector 275 on a backside of a die 240 (or other component) in the system-on-panel 200, the connectors 275 may correspond in function and/or type to those described for connectors 270.

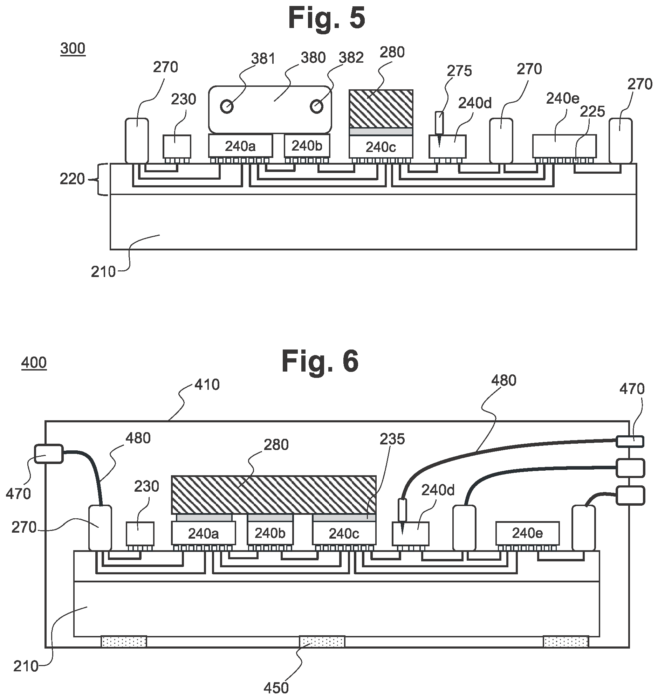

While depicted in Fig. 3 and Fig. 4 in an unconnected state, in general, various cables, wires, cords, leads, or the like would be connected to connectors 270/275 when system-on-panel 200 is installed in a final device application (see e.g., Fig. 6). In general, the manner of making such external connections to connectors 270/275 is not limited in any manner. Direct solder, direct bonding, plugs, pin connectors, physical connectors (e.g., screws, tabs, adhesives, pastes, glues, resins), or the like may be adopted as appropriate.

As depicted in Fig. 3, connectors 270 are shown directly connected to wiring layers in RDL 220, but this is merely schematic and interconnections 225 or similar intervening components may be adopted for such purposes of coupling connectors 270 to wiring in RDL 220. In general, the manner of making connections from connectors 270 to a wiring interconnection within RDL 220 is not limited in any manner. Direct solder, direct bonding, plugs, pin connectors, physical connectors (e.g., screws, tabs, adhesives, pastes, glues, resins), or the like may be adopted as appropriate for connectors 270. Similarly, a connector 270 may merely be a terminal position (e.g., an exposed conductive terminal site, electrode pad, or land) at the surface of RDL 220 that is ultimately directly connected to a wire or the like from an external device for power supply and/or signal I/O. And, as noted, connectors 270 may incorporate, or be integrated with, optical signal handling components for conversion of optical signals to electrical signals and/or electrical signals to optical signals. Likewise, a connector 275 may be mounted on, or disposed upon, a backside of a die 240 in any appropriate manner, such as those discussed for connectors 270. In this context, the backside of a die 240 refers to the side of the die 240 facing generally away from the panel substrate 210. Connectors 275 may also serve the same functions as those discussed for connectors 270. That is, for example, a connector 275 may be an electrical power supply connector, a signal I/O connector, and/or an optical signal connector.

The depicted system-on-panel 200 is shown with a thermal handling structure 280. Thermal handling structure 280 can be, for example, a heat sink, a thermal radiator, a heat transfer structure, a heat exchanger, or the like without limitation. When incorporating only passive thermal management components, such as a heat sink, passive heat conductive transfer elements, or passive radiator/exchanger elements (e.g., fins), the thermal handling structure 280 may be referred to as a passive thermal handling structure. When incorporating active thermal management components or aspects, such as forced flow heat exchangers, fans, thermoelectric coolers, or the like, the thermal handling structure 280 may be referred to as an active thermal control structure.

A passive thermal handling structure is, for example, a passive thermal radiator element configured to receive and radiate away the heat generated by die(s) 240 during operation to ambient atmosphere. A passive thermal handling structure is, for example, a heat transfer structure configured to transfer heat generated by die(s) 240 during operation to a heat sink component and/or ambient atmosphere. A passive thermal handling structure is, for example, a heat sink configured to receive heat generated by die(s) 240 during operation.

An active thermal control structure is, for example, a heat exchanger configured to receive the heat generated by die(s) 240 during operation and transfer this heat to a fluid that flows through the heat exchanger structure. An active thermal control structure includes, for example, a fan configured to promote the transfer of heat generated by die(s) 240 during operation away from the die(s) 240 to ambient atmosphere or otherwise by forced airflow or enhanced convective processes. An active thermal control structure includes, for example, a thermoelectric cooler, such as a Peltier device, configured to provide cooling of dies(s) 240 during operation. An active thermal control structure may be a combination of the various examples above. An active thermal control structure may additionally include control circuits, temperature sensors, thermostats, and the like for controlling active elements, heat exchanger flow rates, fan speeds, and the like. An active thermal control structure may additionally incorporate various passive thermal handling structures, such as the described examples above.

In the present example, thermal handling structure 280 is shown as mounted on multiple dies 240 via a component 235. For example, component 235 is, or comprises, a thermally conductive resin or paste. The number and type of dies 240 (or other components, such as passive components 230) covered or connected to a thermal handling structure 280 is not limited to that depicted. In some examples, thermal handling structure 280 may be omitted. In still other examples, multiple thermal handling structures 280 may be provided. Such multiple instances of thermal handling structure 280 within the same system-on-panel 200 may each be of the same or different types as appropriate for the dies 240 and/or components 230 connected thereto.

Fig. 5 depicts a system-on-panel 300, which is a modification of system-on-panel 200. Aspects of system-on-panel 300 that differ from those of system-on-panel 200 will primarily be described in the following. Those aspects which are not specifically described for the system-on-panel 300 in conjunction with Fig. 5 may be considered to be the same as, or substantially similar to, those of system-on-panel 200 unless otherwise noted.

The system-on-panel 300 incorporates an active thermal control element 380 (thermal control element 300) in addition to a thermal handling structure 280. In this example, the thermal handling structure 280 is shown mounted to die 240c (via component 235), while thermal control element 380 is directly mounted on dies 240a and 240b. Thermal control element 380 of this example may be referred to as an actively controlled thermal management structure or an active thermal control structure. Thermal control element 380 is one, nonlimiting, example of an active thermal control structure. In particular, thermal control element 380 of this example includes a port 381 and a port 382. For example, port 381 is an inflow port via which a temperature-control fluid (e.g., a liquid or gas) is supplied to the interior of thermal control element 380, and port 382 is an outflow port via which the temperature-control fluid exits the interior of thermal control element 380. Generally, tubing, ducting, piping, or the like would be connected to ports 381 and 382 for fluid handling purposes. Such a setup provides an active heat exchanging system for removal of heat generated by dies 240a and 240b. For example, air, inert gas, cooling water, chilled water, coolant, or the like may be supplied to thermal control element 380 from an external source and/or as part of the integration of system-on-panel 300 in a larger device.

In other examples, thermal control element 380 can include a fan configured to promote the transfer of heat away from die(s) 240 during operation by forced airflow or enhanced convective processes. An thermal control element 380 includes, for example, a thermoelectric cooler, such as a Peltier device, configured to provide active cooling of dies(s) 240 during operation. A thermal control element 380 may be a combination of the various examples above. The thermal control element 380 may additionally include control circuits, temperature sensors, thermostats, and the like for controlling active elements, heat exchanger flow rates, fan speeds, and the like. An thermal control element 380 may additionally incorporate various passive thermal handling structures, such as the described examples above
While Fig. 5 does not specifically show any component 235 or the like present between thermal control element 380 and the underlying dies 240a and 240b, such or similar may be present in some examples. In general, the method and manner of making thermal contact between such die 240 and the thermal control element 380 is not limited and any manner and/or to any method. In general, any manner or method may be adopted for this purpose. Likewise, the number of dies 240 to which thermal control element 380 is mounted is not limited to that depicted. A single die 240 may be below thermal control element 380, three or more, or all die 240 present in a system-on-panel 300 may be below thermal control element 380.

While a thermal handling structure 280 is also depicted in system-on-panel 300, such may be optional, and a system-on-panel 300 need not have such in all examples. Similarly, thermal control element 380 may be integrated with thermal handling structure 280 in some examples. For example, thermal control element 380 may be mounted below a thermal handling structure 280 or above a thermal handling structure 280.

### System-in-Box

Fig. 6 depicts a system-on-panel device integrated in a system-in-box 400. In the depicted example, a system-on-panel 200 is shown as integrated in the system-in-box 400; however, a system-on-panel 300 may be similarly integrated in the system-in-box 400 with inclusion of liquid/fluid handling connections to ports 381/382. In general, a system-in-box 400 serves overall packaging and integration functions similar to those of packaged device 100. System-in-box 400 can, however, provide a larger planar area for mounting of dies and other components. Such additional planar area can be utilized for larger device die and/or an increased number of device die.

In addition to the system-on-panel 200, system-in-box 400 depicted in Fig. 6 includes a case 410 (also referred to as a casing, container, device container, covering, system box, box, or the like), external connectors 470, connections 480, and mounts 450. The case 410 is a physical containment structure. The case 410 may be openable and closable, may have a lid, a hatch, or hatches, removable panels, or the like for internal access. The case 410 may be sealed, hermetically sealed, or non-openable or internally accessible. Case 410 may comprise multiple components or parts which are attached to one another to form the casing structure. In some examples, case 410 may be a single, unitary structure. Case 410 may incorporate internal structural supports, be made of different materials, have a window or viewport, have multiple chambers and/or walls. For example, case 410 may be double-walled. The outer shape of case 410 is not limited to that depicted and need not be rectangular, cubic, or regularly or symmetrically shaped. Walls, corners, or portions of case 410 may be hemispherical, ellipsoid, polygonal, irregular, curved, rounded, bent, beveled, or otherwise. The case 410 may be any material and combinations of different materials. For example, case 410 may be metal, plastic, conductive, non-conductive, or combinations thereof.

Mounts 450 are depicted as attachment points and standoffs between case 410 and system-on-panel 200. The number and positioning of mounts 450 is not limited to that depicted. Nor is any or any particular standoff required in this context. Mounts 450 may comprise, for example, adhesive, and panel substrate 210 may be adhered directly to case 410. The attachment to case 410 may be made instead on a sidewall of case 410 rather than on a bottom of case 410. Mounts 450 may be, or incorporate, brackets, fixtures, snap-type structures, standoffs, or the like. Mounts 450 may incorporate or provide shock absorber functions.

External connectors 470 are connection points in the outer wall of case 410 corresponding to the various connectors 270/275 of system-on-panel 200. The number, placement, positioning, and type of connectors 470 is not limited to that depicted or otherwise. For example, connectors 470 may be positioned on a top or bottom wall of case 410, in addition or instead of a sidewall of case 410. The connectors 470 may be electrical connectors for providing electrical power. The connectors 470 may be signal connectors (signal I/O connectors) for supplying external commands to elements (dies 240) and returning information (data) to an external system. Connectors 470 may be optical connectors (e.g., fiber optic connectors) for handling input and/or output of optical signals. The connectors 470 may be, or comprise, terminals/pads for direct soldering, plugs, pin connectors, physical connectors (e.g., screws, tabs, adhesives), or the like. In some examples, connectors 470 may simply be passthroughs for connections 480 when such connections 480 are wires, cables, and/or fibers. Alternatively, connectors 470 may be considered as omitted and corresponding passthroughs, holes, or the like in case 410 may be provided for the connections 480.

Connections 480 may be any appropriate type for connecting between a connector 470 and connector 270 (or connector 275). Connections 480 may be a wire, a wire bundles, a cable, a cord, a fiber optic cable, a fiber optic, or the like. Likewise, end connections from a connection 480 to a connector 270 (or connector 275) at one end and a connector 470 at the other end may be made in any appropriate manner.

In general, panel-type materials and structures that can be used for panel substrate 210 are currently available with high flatness and resistance to warping. In general, panel lithographic/patterning methods for formation of RDL layer 220 (and the wiring interconnections therein) are also available within existing technologies. The various wiring levels of RDL layer 220 may be formed in sequence from the lowermost level to the uppermost. With the inclusion of RDL layer 220 on a single side of panel substrate 210, the thickness dimension of panel substrate 210 may be selected to provide necessary stability and integrity without concern for providing electrical connectivity from a backside of the panel substrate 210 to the front side of the panel substrate 210. For example, the panel substrate 210 may be relatively thick with no particular upper bound on such a dimension being required. For example, the panel substrate 210 may be several millimeters, several tens of millimeters, or more in thickness.

Although one or more embodiments of the present disclosure have been described in some detail for clarity of understanding, certain changes may be made and still be within the scope of the claims. Accordingly, the described embodiments are to be considered as illustrative and not restrictive or limiting, and the scope of the claims is not to be considered limited to details given herein but may be modified while still being within the scope of the claims and equivalents. In the claims, any recitation of elements and/or steps do not imply any particular order of operation or incorporation unless explicitly stated in the claims.

Depicted boundaries between components, elements, devices, and units are somewhat arbitrary, and while particular boundaries may have been illustrated in the context of specific example configurations, other boundaries, divisions, and/or allocations of functions, components, elements, or aspects may be possible or available. Such other allocations of functionality and/or components are envisioned and should be considered to fall within the scope of the present disclosure. In general, structures and functionalities presented as separate components in exemplary configurations may be implemented as a combined structure or component. Similarly, structures and functionalities presented as a single component may be implemented as separate components. These and other variations, additions, alterations, and improvements may fall within the scope of the appended claims.

## Claims

1. A system-on-panel device, comprising:
a panel substrate;
a redistribution layer on the panel substrate and including a plurality of wiring connections;
a plurality of device dies on the redistribution layer, the plurality of device dies being electrically connected to at least one wiring connection in the plurality of wiring connections; and
a first connector on the redistribution layer, the first connector being electrically connected to at least one wiring connection in the plurality of wiring connections.

2. The system-on-panel device of claim 1, further comprising:
a second connector on a backside of a device die of the plurality of device dies, the second connector being electrically connected to the device die;
wherein in particular
the second connector is an electrical power supply connector.

3. The system-on-panel device of claim 1 or 2, further comprising:
a passive component on the redistribution layer and electrically connected to at least one wiring connection in the plurality of wiring connections;
wherein in particular
the passive component is a resistor.

4. The system-on-panel device of any one of the claims 1 to 3, wherein the redistribution layer comprises a plurality of wiring layers stacked one upon the other.

5. The system-on-panel device of any one of the claims 1 to 4, further comprising:
a passive thermal handling structure on a backside of one or more device dies in the plurality of device dies.

6. The system-on-panel device of any one of the claims 1 to 5, further comprising:
an active thermal control structure on a backside of one or more device dies in the plurality of device dies, the active thermal control structure including fluid handling ports therein.

7. The system-on-panel device of any one of the claims 1 to 6, wherein
the first connector is an optical signal connector.

8. The system-on-panel device of any one of the claims 1 to 7, wherein
the first connector is an electrical power supply connector.

9. The system-on-panel device of any one of the claims 1 to 8, wherein
the panel substrate is a glass panel.

10. The system-on-panel device of any one of the claims 1 to 9, wherein
the panel substrate has a maximum planar dimension of at least 500mm.

11. A system-in-box device, comprising:
a casing surrounding an interior space;
an external connector on an outer wall of the casing; and
a system-on-panel device according to any one of the claims 1 to 10 within the interior space, wherein
the external connector is connected to the first connector by a wire within the interior space.

12. A system-on-panel device, comprising:
a panel substrate;
a redistribution layer on a first surface side of the panel substrate and including a plurality of wiring connections in a plurality of wiring layers;
a first device die mounted on the redistribution layer;
a second device die mounted on the redistribution layer; and
a first connector on the first surface side of the panel substrate and electrically connected to at least one wiring connection in the plurality of wiring connections, wherein the first device die is electrically connected to the first connector via the at least one wiring connection in the plurality of wiring connections and to the second device die via at least one other wiring connection in the plurality of wiring connections.

13. The system-on-panel device according to claim 12, wherein
the panel substrate is a rectangular glass substrate with a maximum planar dimension of at least 500mm;
and or wherein
the first device die and the second device die are mounted on the redistribution layer via solder balls.

14. The system-on-panel device according to claim 12 or 13, further comprising:
a second connector on a backside of the second device die;
and/or further comprising
a thermal handling structure mounted on a backside of the first and second device die.

15. A system-in-box, comprising:
a casing;
an external connector on an exterior wall of the casing; and
a system-on-panel device inside the casing and including:
a panel substrate;
a redistribution layer on the panel substrate and including a plurality of wiring connections;
a plurality of device dies on the redistribution layer, the plurality of device dies being electrically connected to at least one wiring connection in the plurality of wiring connections; and
a panel connector on the redistribution layer, the panel connector being electrically connected to at least one wiring connection in the plurality of wiring connections, wherein
the external connector is connected to the panel connector;
wherein in particular
the panel connector is an optical signal connector.
